# EUROPEAN PATENT APPLICATION

(11) **EP 1 615 473 A1**
(43) Date of publication of application: **11.01.2006**
(21) Application number: 03717593.2
(22) Date of filing: 15.04.2003
(51) Int. Cl.: H05B 33/12, H05B 33/22, H05B 33/14

(54) **ORGANIC EL DISPLAY**

(71) Applicant: FUJITSU LIMITED, Kawasaki-shi, Kanagawa 211-8588 (JP)
(72) Inventor: YAEGASHI, Hiroyuki, c/o FUJITSU LIMITED, Kawasaki-shi, Kanagawa 211-8588 (JP)
(74) Representative: Sunderland, James Harry
(86) International application number: PCT/JP2003/004776
(87) International publication number: WO 2004/093500

(57) **Abstract**

An organic EL display apparatus is disclosed that includes a substrate, a thin film transistor formed on the substrate, an insulation film formed on the substrate in a manner covering the thin film transistor, and an organic EL element formed on the insulation film. The insulation film is formed with a recess portion. The organic EL element is formed in a manner contacting the thin film transistor via the recess portion formed in the insulation film.

## Description

### TECHNICAL FIELD

The present invention relates to an organic electroluminescence display apparatus, and more particularly to a flat display apparatus using an organic electroluminescence element.

An organic EL (electroluminescence) element is an organic light emitting element having an organic EL light emitting layer sandwiched between an electron transport layer and a hole transport layer, and is considered to be a promising display serving as a light emitting type display element that is small/lightweight/low power consuming and also provides a wide viewing angle.

In a case of forming a high definition flat light emitting apparatus using such an organic EL element, it is desirable to configure a flat light emitting apparatus of the so-called active matrix type which has a large number of light emitting elements, each provided with an organic EL element, allocated on a substrate in a matrix-like manner, and drives the light emitting elements with corresponding thin film transistors (TFT) disposed on the substrate.

### BACKGROUND ART

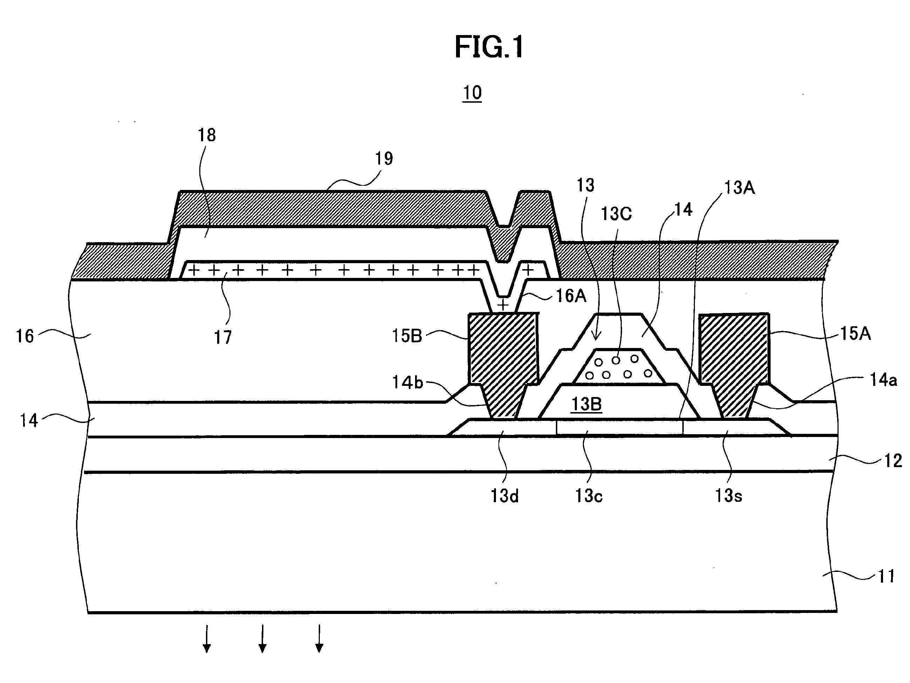

Fig.1 shows an example of an active matrix type flat display apparatus 10 using an organic EL element.

With reference to Fig.1, the flat display apparatus 10, which is a bottom emission type display apparatus disposed on a transparent glass substrate 11, includes a TFT 13 formed on the glass substrate 11 via a buffer layer 12.

The TFT 13, which is formed of polysilicon or amorphous silicon, includes a silicon pattern 13A having a source diffusion area 13s and a drain diffusion area 13d, a gate insulation film 13B covering a channel area 13c of the silicon pattern 13A between the source diffusion area 13s and the drain diffusion area 13d, and a gate electrode 13C serving as a scanning bus line formed on the gate insulation film 13B. The TFT 13 is coated with a CVD insulation film 14, for example, SiO₂.

The CVD insulation film 14 is formed with contact holes 14a and 14b for exposing the source diffusion area 13s and the drain diffusion area 13d, respectively. Electrodes 15A and 15B are formed in the contact holes 14a and 14b for contacting with the source diffusion area 13s and the drain diffusion area 13d, respectively. The electrode 15A extends over the insulation film 14 to form a data bus line.

A planarized insulation film 16 is formed on the insulation film 14 in a manner covering the electrodes 15A and 15B. Provided sequentially on the planarized insulation film 16 are: a lower electrode 17, which is formed of a transparent electric conductor such as ITO, and is provided on the planarized insulation film 16 in a manner contacting the electrode 15B via a contact hole 16A formed in the insulation film 16; an organic EL layer 18 formed on the lower electrode 17A; and an upper electrode 19 formed on the organic EL layer 18.

Although not shown in the drawing, the organic EL layer 18, which includes an organic EL light emitting layer sandwiched between an electron transport layer and a hole transport layer, creates emission of a predetermined color by being driven by the TFT 13. In the flat display apparatus 10 shown in Fig.1, the created emission is emitted downward through the glass substrate 11.

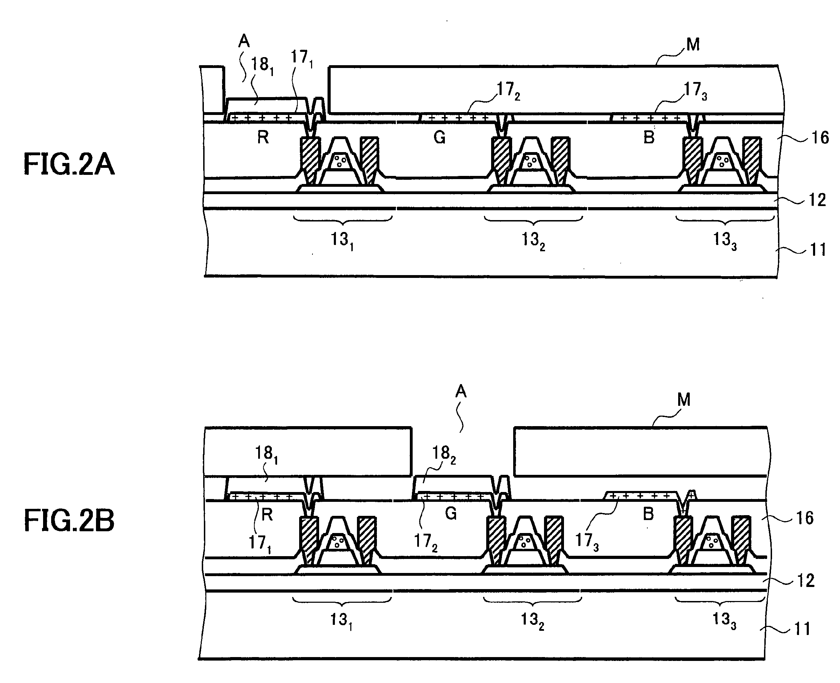

Figs.2A through 2C show a process of manufacturing the flat display apparatus 10.

With reference to Fig.2A, multiple TFTs 13₁-13₃ are formed on the glass substrate 11 in correspondence with numerous display pixels. The planarized insulation film 16 is formed in a manner covering all of the TFTs 13₁-13₃. In a step shown in Fig.2A, lower electrodes 17₁-17₃ are formed on the surface of the planarized insulation film 16 in correspondence with the TFTs 13₁-13₃. Employing a mask pattern M having a mask opening part A as a mask, an organic EL layer 18₁ emitting a red (R) light is formed on the lower electrode 17₁ by, for example, vacuum deposition.

Next, in a step shown in Fig.2B, the mask pattern M is moved to a position where the opening part A exposes the lower electrode 17₂. By executing vacuum deposition via the mask pattern M, an organic EL layer 18₂ emitting a green (G) light is formed on the lower electrode 17₂.

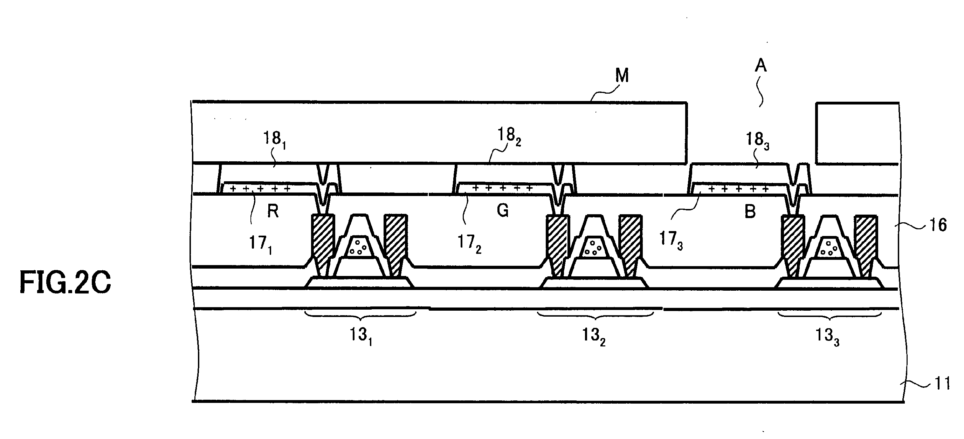

Furthermore, in a step shown in Fig.2C, the mask pattern M is moved to a position where the opening part A exposes the lower electrode 17₃. By executing vacuum deposition via the mask pattern M, an organic EL layer 18₃ emitting a blue (G) light is formed on the lower electrode 17₃.

In the process of manufacturing the organic EL flat display apparatus as shown in Fig.2B or Fig.2C, the mask pattern M physically contacts the fabricated organic EL layers 18₁-18₃ during the step of depositing the organic EL layers. Accordingly, the extremely thin organic EL layers are susceptible to damage, thereby leading to decrease of yield in manufacturing the flat display apparatus. Furthermore, the physical contact with the organic EL layers may also damage the mask pattern M. Accordingly, in such a case where the mask pattern M is damaged, defects created by such damage are transferred to all pixels formed later on.

Furthermore, in the step shown in Fig.2A, the mask pattern M also contacts the lower electrode 17₂ and 17₃, thereby leading to damage thereof.

In order to solve the foregoing problems, Japanese Laid-Open Patent Application No.8-315981 discloses a configuration where a partition is formed for partitioning pixel areas on a substrate and the partition is engaged with a deposition mask when forming an organic EL layer in the pixel areas by vacuum deposition, for example.

Fig.3 shows the conventional configuration disclosed in Japanese Laid-Open Patent Application No.8-315981.

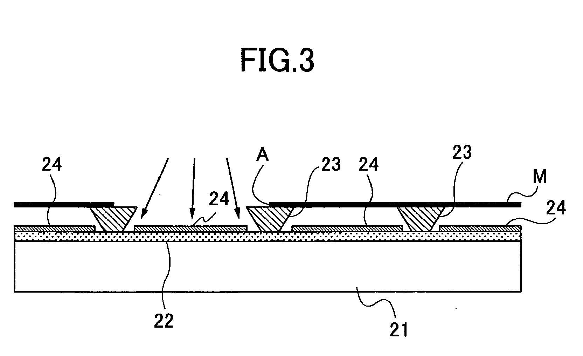

With reference to Fig.3, stripe-like lower electrodes 22 are repeatedly formed on a glass substrate 21. Furthermore, partitions 23, which have an upside down trapezoid shaped cross section, are repeatedly formed on the lower electrodes 22 in a manner perpendicularly intersecting with an extending direction of the stripes of electrodes 22.

Furthermore, organic EL layers 24 are formed on the lower electrodes 22 by executing vacuum deposition in a state where the partitions 23 are engaged with a deposition mask having an opening part A.

The formation of the partitions 23, however, has problems of being complicated, requiring extra steps such as deposition of an insulation layer and patterning, etc., and increasing manufacturing cost of the flat display apparatus. Furthermore, the conventional example shown in Fig.3 is applied to a flat display apparatus of a passive matrix type using perpendicularly intersecting stripe-like lower electrode patterns and upper electrode patterns. However, in applying the configuration of the conventional example to a flat display apparatus of an active matrix type using the TFT shown in Fig.1, the partitions 23 are required to be formed after the TFT 13 is covered with the planarized insulation film.
- (Patent Document 1): Japanese Laid-Open Patent
Application No.8-315981
- (Patent Document 2): Japanese Laid-Open Patent
Application No.10-189252
- (Patent Document 3): Japanese Laid-Open Patent
Application No.2001-356711

### DISCLOSURE OF INVENTION

Accordingly, it is a general object of the present invention to provide a novel and useful organic EL display apparatus and a manufacturing method thereof that obviate the above-described problems.

A more specific object of the present invention is to provide a method of manufacturing an organic EL display apparatus which method is easy and provides satisfactory yield.

Another object of the present invention is to provide an organic EL display apparatus including a substrate, a thin film transistor formed on the substrate, an insulation film formed on the substrate in a manner covering the thin film transistor, and an organic EL element formed on the insulation film, wherein the insulation film is formed with a recess portion, wherein the organic EL element is formed in a manner contacting the thin film transistor via the recess portion formed in the insulation film.

Another object of the present invention is to provide a method of manufacturing an organic EL flat display apparatus including the steps of forming an insulation film on a substrate with a thin film transistor formed thereto in a manner covering the thin film transistor, forming a recess portion in the insulation film, and forming an organic EL element in the recess portion, wherein the step of forming the organic EL element is executed with a mask having a mask pattern engaged with a surface of the insulation film.

With the present invention, by forming a recess portion in an insulation film having an organic EL element covering a thin film transistor, and thus by forming the recess portion in an organic EL layer, an evaporation mask used in forming a lower electrode or an organic EL layer can be prevented from physically contacting the formed lower electrode or organic EL layer. Accordingly, an improved yield can be attained in manufacturing an organic EL flat display apparatus of an active matrix type.

Features and advantages of the present invention will be set forth in the description which follows, and in part will become apparent from the description and the accompanying drawings.

### BRIEF DESCRIPTION OF THE DRAWINGS

Fig.1 is a drawing showing a basic configuration of an organic EL flat display apparatus of an active matrix type that is driven by TFT;
Figs.2A-2C are drawings showing processes of manufacturing the organic EL flat display apparatus shown in Fig.1;
Fig.3 is a drawing showing a process of manufacturing a conventional organic EL flat display apparatus;
Figs.4A-4G are drawings showing processes of manufacturing an organic EL flat display apparatus according to a first embodiment of the present invention;
Fig.5 is an external view of an organic EL flat display apparatus according to a first embodiment of the present invention;
Fig.6 is a drawing showing a modified example of the organic EL flat display apparatus shown in Fig.5;
Fig.7 is a drawing showing a configuration of an organic EL flat display apparatus according to a second embodiment of the present invention; and
Fig.8 is a drawing showing a process of manufacturing an organic EL flat display apparatus according to a third embodiment of the present invention.

### BEST MODE FOR CARRYING OUT THE INVENTION

### [First Embodiment]

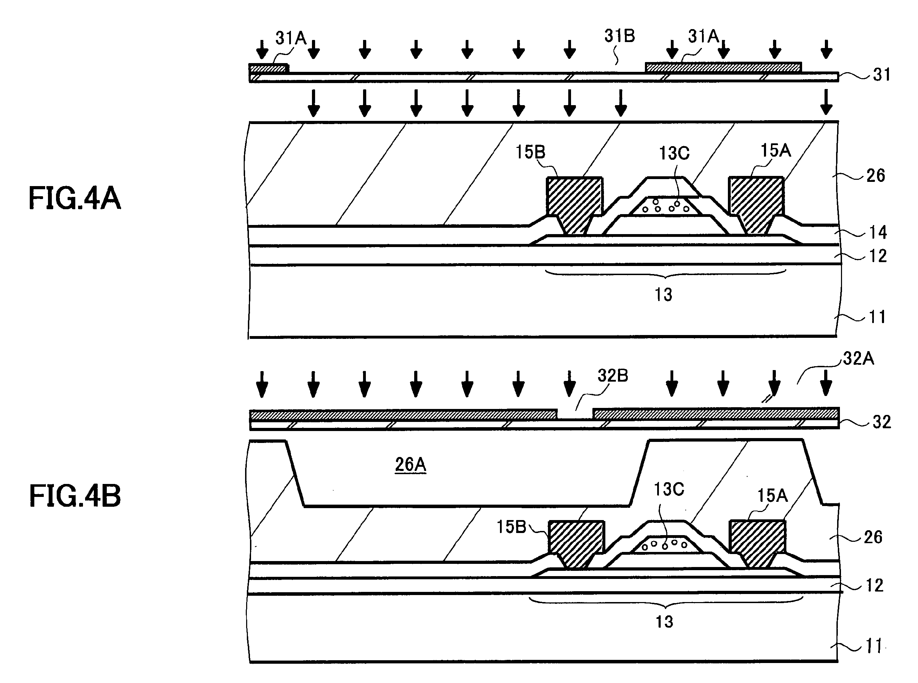

Figs.4A-4G show a process of manufacturing an organic EL flat display apparatus 20 according to a first embodiment of the present invention. In the drawings, however, reference numbers of the above-described components are denoted with the same references numbers and description thereof is omitted.

With reference to Fig.4A, a TFT 13 is formed on a glass substrate 11 via a buffer layer 12 formed of, for example, SiO2. The TFT 13 is covered by a CVD insulation film 14 formed by a low temperature process such plasma CVD.

In the step shown in Fig.4A, a photosensitive planarized film 26, including, for example, acrylic resin or resist film, is coated on the CVD insulation film 14 to a thickness of 2-3µm, for example, by employing a typical coating method. The planarized film 26 formed in such manner has a characteristic of having a planar surface.

Furthermore, in the step shown in Fig.4A, the planarized film 26 is exposed to ultraviolet light with use of an optic mask 31 having an opaque pattern 31A.

More specifically, after coating of the planarized film 26, the planarized film 26 is subjected to a pre-bake process at a temperature of 80°C. In the exposure process, a mercury lamp with a wavelength of 405 nm, for example, is employed as the light source for exposure, in which the amount of exposure is set to, for example, 200 mJ/cm² for preventing the planarized film 26 from being entirely exposed in a thickness direction.

By developing the exposed planarized film 26, a recess portion(s) 26A, typically having a depth of 0.1-0.5 µm, is formed in the planarized film 26 in correspondence with an optical window portion part(s) 31B partitioned by the opaque pattern 31A. The recess portions 26A correspond to the multiple pixel areas being formed on the substrate 11 in a matrix-like manner. The bottom surface of the recess portions 26A is formed by the planarized film 26.

Next, in a process shown in Fig.4B, the configuration shown in Fig.4A is subject to an exposure process with use of an optic mask 32 having an opaque pattern 32A. The opaque pattern 32A serves to partition an optical window(s) 32B corresponding to the electrode(s) 15B. As a result, in the exposure process shown in Fig.4B, the planarized film 26 is exposed at portions covering the electrodes 15B.

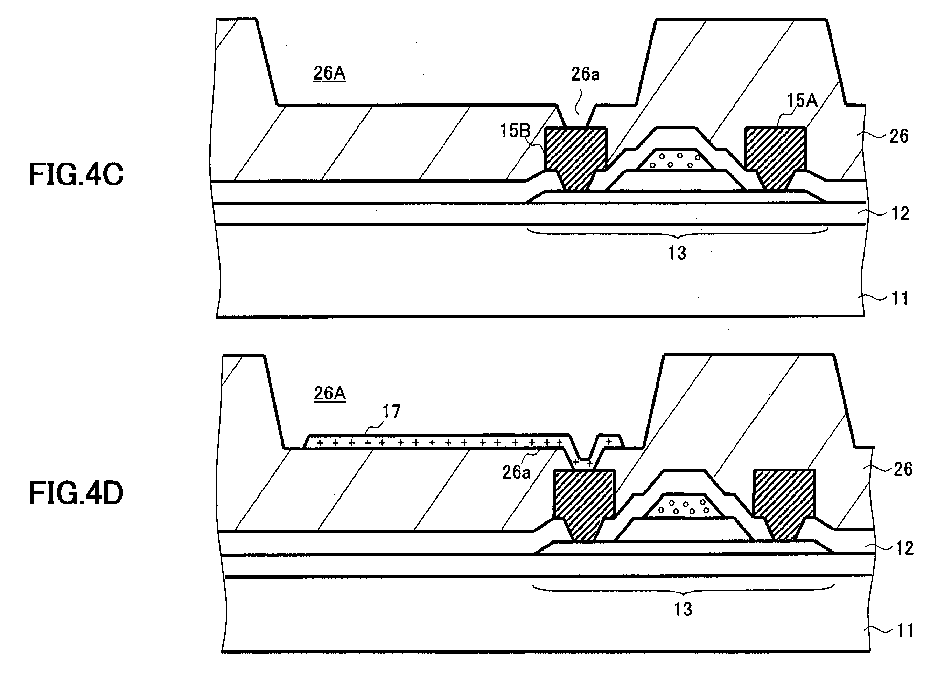

Furthermore, the exposed planarized film 26 is developed and is subjected to a post-bake process, for example, at a temperature of 200 °C for 60 minutes. Accordingly, a contact hole(s) 26a exposing the electrode 15B is formed at a bottom part of the recess portion 26A, as shown in Fig.4C.

It is to be noted that the foregoing describes an example where the recess portion 26A is formed by developing the planarized film 26 in the process shown in Fig.4B subsequent to the exposure process of Fig.4A. Practically, however, it is more preferable to execute the exposure process of Fig.4B and the development and the post-bake process of Fig.4C immediately after the exposure process of Fig.4A.

In a process shown in Fig.4D, a transparent conductive film, such as ITO (In₂O₃ · SnO₂), is deposited by sputtering in a manner covering the bottom part of the recess portion 26A and contacting the electrode 15B at the contact hole 26a, and is patterned with a photolithographic process; thereby a lower electrode 17 is formed.

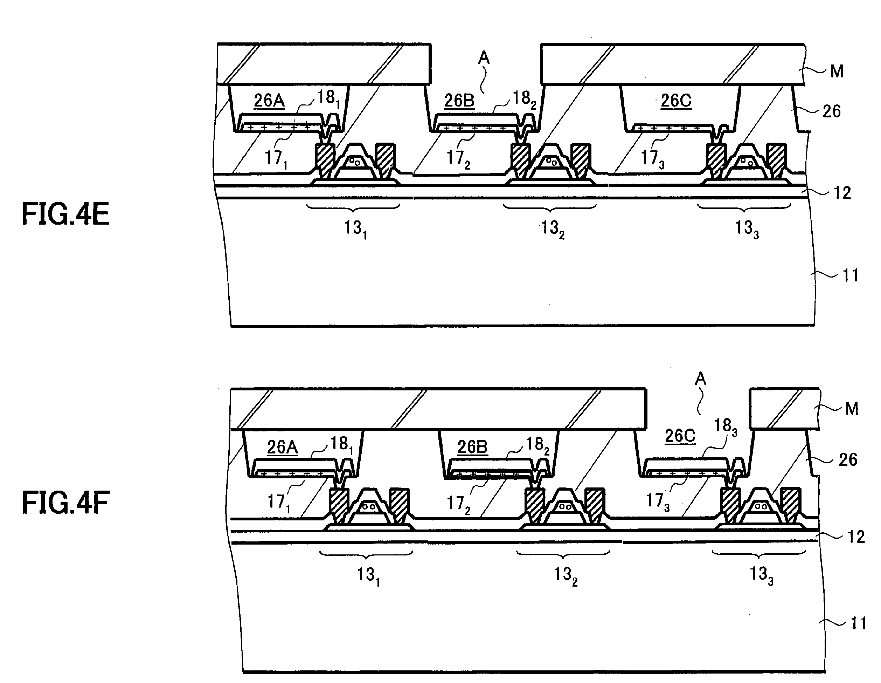

Accordingly, as shown in Fig.4E, recess portions 26A-26C are formed in the planarized film 26 in correspondence with the TFTs 13₁-13₃, and lower electrodes 17₁-17₃ (being formed of ITO, for example) are formed in electrical connection with corresponding TFTs 13₁-13₃.

Similar to the example shown in Fig.1, the lower electrode 17₁ forms a red pixel area, the lower electrode 17₂ forms a green pixel area, and the lower electrode 17₃ forms a blue pixel area.

In a process shown in Fig.4E, the planarized film 26, having the recess portions 26A-26C formed thereto, is engaged with an evaporation mask M having an opening part A. As shown in Figs.4E and 4F, the evaporation mask M is moved from one recess portion (e.g. 26A) to another recess portion (e.g. 26B) on the planarized film 26, and vacuum evaporation is executed via the evaporation mask M each time the evaporation mask M is moved. Accordingly, a red light emitting organic EL layer 18₁, a green light emitting organic EL layer 18₂, and a blue light emitting organic EL layer 18₃ are sequentially formed in corresponding lower electrodes 17₁-17₃.

In the processes shown in Figs.4E and 4F, the evaporation mask M is engaged with the planarized film 26 at step portions thereof surrounding the recess portions 26A, 26B or 26C. Accordingly, since the organic EL layers 18₁-18₃ formed in the recess portions 26A-26C do not contact the evaporation mask M, the processes of this example do not cause the problem of having the organic EL layers damaged by contact with the evaporation mask M.

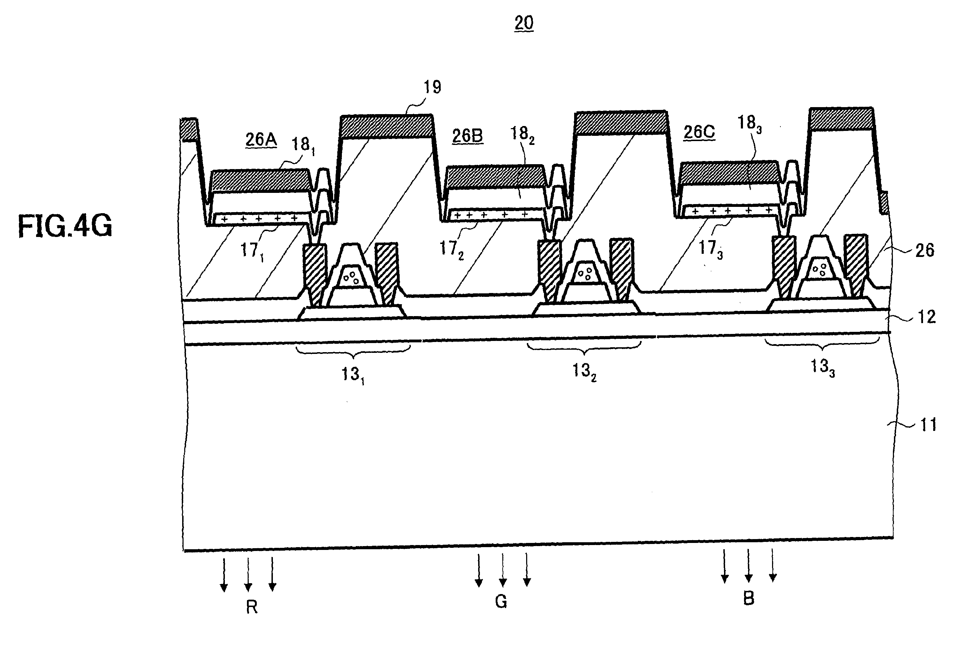

Furthermore, in a process shown in Fig.4G, the evaporation mask M is removed and a metal film, Al, for example, is uniformly deposited thereon to form an upper electrode 19.

With the processes of Fig.4A-4G, the recess portions 26A-26C, which prevent the mask M from contacting the organic EL layers or the lower electrodes, can be obtained simply by exposing and developing the planarized film 26 at portions covering the TFTs. Accordingly, an organic EL flat display apparatus of an active matrix type can be manufactured with considerable ease and high yield without having to form a separate structure such as a partition.

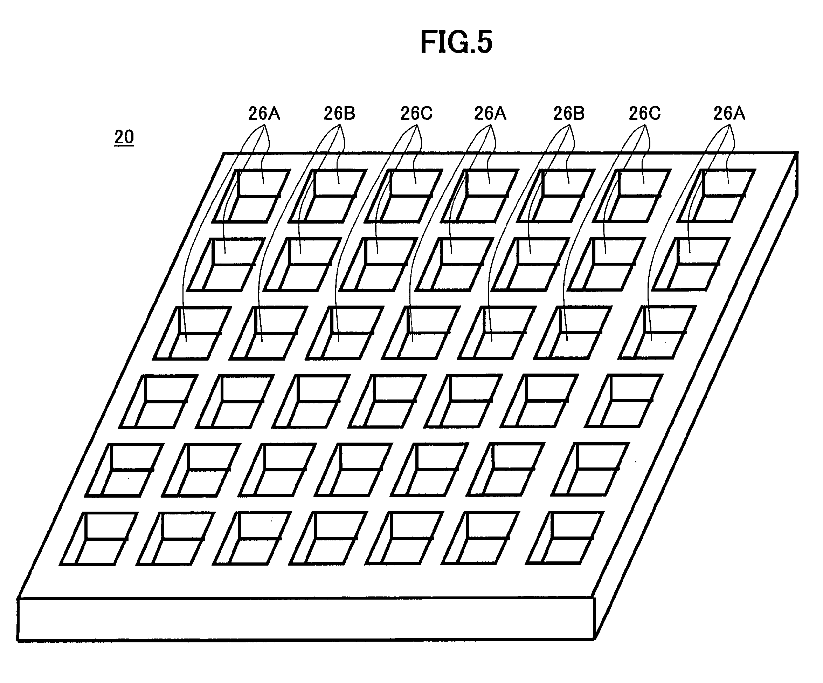

Fig.5 is a perspective view of a flat display apparatus 20 formed by the above-described processes.

Fig.5 shows multiple recess portions 26A-26C, corresponding to pixel areas of red/green/blue, being repeatedly formed in a matrix-like manner at a rear side of the flat display apparatus 20, that is, the upper side in Fig.4G. Furthermore, the side at which the recess portions 26A-26C are formed is covered by an Al electrode layer 19.

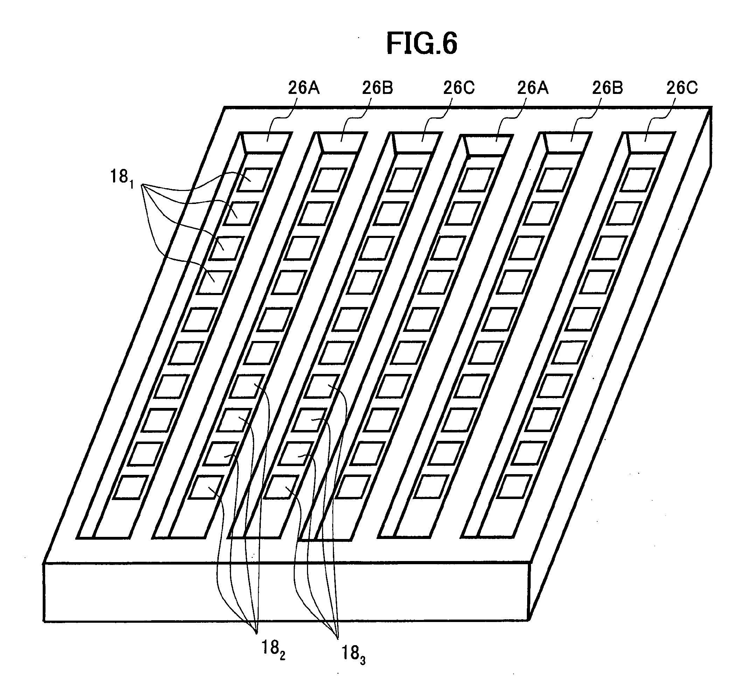

The recess portions 26A-26C may be formed in a groove-like manner shown in Fig.6 according to necessity. In this case, multiple red light emitting organic EL layer patterns 18₁ are allocated in the groove 26A, multiple green light emitting organic layer patterns 18₂ are allocated in the groove 26B, and multiple blue light emitting organic layer patterns 18₃ are formed in the groove 26C.

### [Second Embodiment]

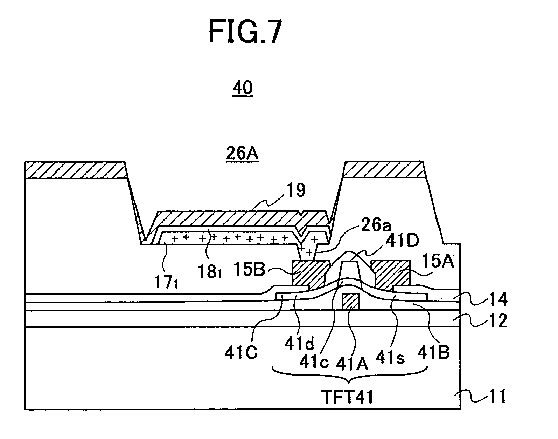

Fig.7 is an organic EL flat display apparatus 40 according to a second embodiment of the present invention. In this embodiment, a gate electrode 41A, being formed of amorphous silicon or polysilicon, is disposed on a buffer layer 12 covering the glass substrate 11, and an insulation film 41B, serving as a gate insulation film, is formed on the buffer layer 12 in a manner covering the polysilicon gate electrode 41A.

Furthermore, a semiconductor layer 41C, being formed of amorphous silicon or polysilicon, is disposed on the insulation film 41B, and an insulation film pattern 41D is disposed on the semiconductor layer 41C at a position corresponding to the gate electrode 41A. By adding an impurity element by ion injection with the insulation pattern 41D as a mask, a source area 41s and a drain area 41d are formed in the semiconductor layer 41C in a state separated by a channel area 41c situated therebetween.

Furthermore, the semiconductor layer 41C is covered by the CVD insulation film 14. A source electrode 15A and a drain electrode 15B, having a contact hole therebetween, are formed on the CVD insulation film 14 in a manner contacting the source area 41s and the drain area 41d.

The gate electrode 41A, the gate insulation film 41B, and the semiconductor film 41C form a TFT 41. Similar to the foregoing embodiment, the TFT 41 is covered by a planarized film 26.

A recess portion(s) 26A is formed in the planarized insulation film 26 in correspondence with a pixel area. A contact hole 26a is formed in a portion of the planarized insulation film 26 in a manner exposing the drain electrode 15B.

A transparent electrode 17₁, being formed of ITO, for example, is disposed at a bottom part of the recess portion 26A. The transparent electrode 17₁ is covered by an organic EL layer 18₁ at the bottom part of the recess portion 26A. Furthermore, an upper electrode 19 is formed on the organic EL layer 18₁.

According to this embodiment of the present invention, the organic EL flat display apparatus can be provided with the TFT 41 having its gate electrode and semiconductor layer in a reverse relation with respect to that of the TFT 13 in the foregoing embodiment.

### [Third Embodiment]

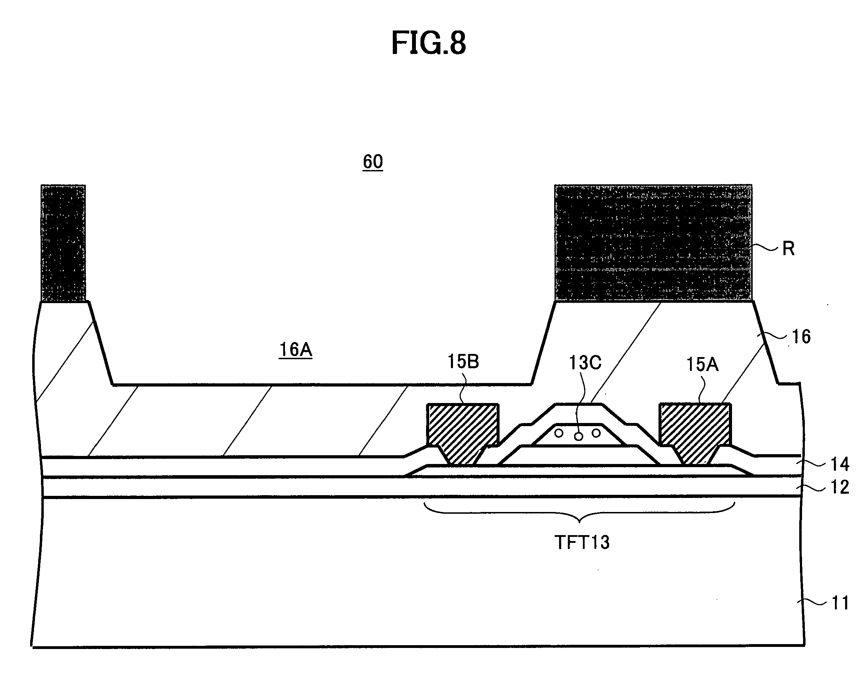

Fig.8 shows a process of manufacturing an organic EL flat display apparatus 60 according to a third embodiment of the present invention. In the drawing, however, reference numbers of the above-described components are denoted with the same references numbers and description thereof is omitted.

The process shown in Fig.8 corresponds to the processes shown in Figs.4A and 4B. In this embodiment, instead of the photosensitive film 26, an insulation film 16 having no photosensitivity, such as a normal plasma CVD-SiO₂ film, is used as the planarized insulation film.

Accordingly, in the process shown in Fig.8, a resist pattern R is formed on the insulation film 16. By wet-etching the insulation film 16 with the resist pattern R as a mask, a recess portion 16A is formed in the insulation film 16.

Processes following this process are the same as those of the foregoing embodiment. This embodiment also enables an organic EL flat display apparatus of an active matrix type to be manufactured with ease and high yield.

Particularly, in this embodiment, the insulation film 16 requires no coating, and thus does not require (although preferable) a planarized film being characterized by its planar face. It is, however, possible to employ a coating film such as an organic SOG film or an organic insulation film for the insulation film 16 in the process shown in Fig.8.

Further, the present invention is not limited to these embodiments, but variations and modifications may be made without departing from the scope of the present invention.

### Industrial Applicability

With the present invention, by forming a recess portion in an insulation film having an organic EL element covering a thin film transistor, and thus by forming the recess portion in an organic EL layer, an evaporation mask used in forming a lower electrode or an organic EL layer can be prevented from physically contacting the formed lower electrode or organic EL layer. Accordingly, an improved yield can be attained in manufacturing an organic EL flat display apparatus of an active matrix type.

## Claims

1. An organic EL display apparatus comprising:
a substrate;
a thin film transistor formed on the substrate;
an insulation film formed on the substrate in a manner covering the thin film transistor; and
an organic EL element formed on the insulation film;
wherein the insulation film is formed with a recess portion, wherein the organic EL element is formed in a manner contacting the thin film transistor via the recess portion formed in the insulation film.

2. The organic EL display apparatus as claimed in claim 1, wherein the insulation film is a coating film.

3. The organic EL display apparatus as claimed in claim 1, wherein the insulation film is a CVD film.

4. The organic EL display apparatus as claimed in claim 1, wherein the insulation film has photosensitivity.

5. The organic EL display apparatus as claimed in claim 1, wherein plural of the thin film transistors are formed on the substrate, wherein plural of the organic EL elements are formed on the substrate in correspondence with the thin film transistors, wherein plural of the recess portions are formed in the insulation film in correspondence with the organic EL elements.

6. A method of manufacturing an organic EL flat display apparatus comprising the steps of:
forming an insulation film on a substrate with a thin film transistor formed thereto in a manner covering the thin film transistor;
forming a recess portion in the insulation film; and
forming an organic EL element in the recess portion;
wherein the step of forming the organic EL element is executed with a mask having a mask pattern engaged with a surface of the insulation film.

7. The method of manufacturing an organic EL flat display apparatus as claimed in claim 6, wherein the step of forming the insulation film includes a step of forming an insulation film having photosensitivity, wherein the step of forming the recess portion includes the steps of exposing the insulation film and developing thereafter.

8. The method of manufacturing an organic EL flat display apparatus as claimed in claim 7, wherein the step of forming the recess portion includes the steps of forming a resist pattern on the insulation film and etching the insulation film with the resist pattern as a mask.
